# EUROPÄISCHE PATENTSCHRIFT

(11) **EP 2 238 413 B1**
(45) Veröffentlichungstag und Bekanntmachung des Hinweises auf die Patenterteilung: **30.03.2016**
(21) Anmeldenummer: 09703424.3
(22) Anmeldetag: 23.01.2009
(51) Int. Cl.: G01D 3/028, B60T 8/171, G01K 7/01, G01R 19/00, H02M 3/156, H02M 1/00

(54) **ELEKTRONISCHE SCHALTUNGSEINRICHTUNG ZUR ERFASSUNG EINES DETEKTIONSELEMENTSTROMS UND/ODER EINER TEMPERATUR IN DIESEM DETEKTIONSELEMENT**
ELECTRONIC SWITCHING DEVICE FOR THE DETECTION OF A DETECTION ELEMENT STREAM AND/OR A TEMPERATURE IN SAID DETECTION ELEMENT
SYSTÈME DE CIRCUIT ÉLECTRONIQUE POUR DÉTECTER UN COURANT D'ÉLÉMENT DE DÉTECTION ET/OU UNE TEMPÉRATURE À L'INTÉRIEUR DE CET ÉLÉMENT DE DÉTECTION

(30) Priorität: 25.01.2008 DE 102008006252; 03.11.2008 DE 102008055696
(43) Veröffentlichungstag der Anmeldung: 13.10.2010
(73) Patentinhaber: Continental Teves AG & Co. OHG, 60488 Frankfurt (DE)
(72) Erfinder: KUTZNER, Michael, 65843 Sulzbach (DE); UNGER, Tobias, 65474 Bischofsheim (DE)
(74) Vertreter: Brand, Markus
(86) Internationale Anmeldenummer: PCT/EP2009/050772
(87) Internationale Veröffentlichungsnummer: WO 2009/092788

(56) Entgegenhaltungen:
- EP-A2- 0 747 713
- US-A1- 2006 250 153

## Beschreibung

Die Erfindung betrifft eine elektronische Schaltungseinrichtung gemäß Oberbegriff von Anspruch 1, ein Verfahren zur Stromerfassung, ein Verfahren zur Temperaturerfassung sowie die Verwendung der Schaltungseinrichtung in Kraftfahrzeugen.

Im Bereich der elektronischen Bremsensteuergeräte werden induktive Lasten, wie zum Beispiel Ventilspulen oder Pumpenmotore, mittels eines Halbleiterschalterelements getaktet angesteuert (PWM-Ansteuerung). Eine entsprechende Lastansteuerungsschaltung muss so aufgebaut sein, dass der in der Rezirkulationsphase entstehende Freilaufstrom auf Grund der Lastinduktivität fließen kann. Hierzu weist das Halbleiterschalterelement eine Freilaufdiode auf. Es hat sich als vorteilhaft herausgestellt, das Halbleiterschalterelement während der Rezirkulationsphase zumindest bei Überschreitung eines definierten Freilaufstroms niederohmig zu schalten, wodurch die elektrischen Schaltverluste der PWM relativ klein gehalten werden können.

Um einen solchen aktiven Freilauf realisieren zu können, ist es nötig, den Strom in der den Freilauf realisierenden Freilaufdiode bzw. in einem Detektionselement zu bestimmen.

Außerdem ist es häufig wünschenswert, die Temperatur in einem Detektionselement, insbesondere in einer Freilaufdiode, einer elektronischen Schaltung zu erfassen.

Aus der US 2006/250153 A1 gehen ein Verfahren und eine Schaltungsanordnung zur Berechnung eines Stromes durch einen MOSFET, umfassend einen Haupt- und einen Spiegel-MOSFET, hervor. Dabei wird unter anderem mit Hilfe einer erfassten Spannung über einen ohmschen Widerstand der Strom durch den MOSFET nach analog-digital Wandlung mittels Mikrocontroller berechnet.

In der EP 0 747 713 A2 wird eine Schaltungsanordnung zum Erfassen des Laststromes eines durch Feldeffekt steuerbaren Leistungs-Halbleiterbauelements vorgestellt, bei der zusätzlich zu einem "Sense"-FET ein steuerbarer Widerstand zwischen dem Messausgang und einem an Masse liegenden Messwiderstand angeschlossen und durch entsprechende Widerstandsanpassung eine Proportionalität von Last- und Messstrom erreicht wird.

Die Aufgabe der vorliegenden Erfindung besteht darin, eine elektronische Schaltungseinrichtung zur Erfassung eines Detektionselementstroms durch ein Detektionselement und/oder einer Temperatur in diesem Detektionselement vorzuschlagen, wobei diese relativ kostengünstig sein soll.

Diese Aufgabe wird erfindungsgemäß gelöst durch die elektronische Schaltungseinrichtung gemäß Anspruch 1 und die Verfahren gemäß Anspruch 15 und 16.

Das erste und zweite Transistorelement sind alternativ als bipolare Transistorelemente oder als FETs, insbesondere JFETs ausgebildet.

Unter der Erfassung eines Detektionselementstroms durch das Detektionselements wird bevorzugt eine Messung des Detektionselementstrom, insbesondere bei im Wesentlichen bekannter Temperatur des Detektionselements und/oder das Erfassen des Überschreitens eines definierten Stromschwellwerts durch den Detektionselementstrom, verstanden.

Unter der Erfassung einer Temperatur in dem Detektionselement wird bevorzugt eine Messung der Temperatur, insbesondere bei im Wesentlichen bekanntem Detektionselementstrom, in dem Detektionselement und/oder das Erfassen des Überschreitens einer definierten Temperaturschwelle in dem Detektionselement, verstanden.

Unter einer Strom-Spannungs-Kennlinie wird vorzugsweise ebenfalls eine Kennlinie oder Kennlinienschar verstanden, welche die Temperaturabhängigkeit von Strom und/oder Spannung zeigt und entsprechend eine Temperaturabhängigkeitsinformation umfasst.

Die elektronische Schaltungseinrichtung stellt vorzugsweise das elektrische Auswertesignal als "verstärkten" Messstrom einer über dem Detektionselement anliegenden Spannung bereit.

Das Detektionselement ist beispielsweise ein Halbleiterbauelement, insbesondere die Bulkdiode bzw. Bodydiode eines FETs. Vorzugsweise ist das Detektionselement als Freilaufdiode ausgebildet, welche in einer gemeinsamen Schaltungsmasche mit einer induktiven Last angeordnet ist und diese induktive Last insbesondere als Ventilspule und/oder Motor, besonders bevorzugt als Pumpenmotor, ausgebildet ist.

Das Detektionselement ist alternativ vorzugsweise als Verpolschutzdiode ausgebildet. Dabei soll insbesondere deren Temperatur und/oder ein möglicher Kurzschlussstrom mittels der erfindungsgemäßen Schaltungseinrichtung erfasst werden. Das Detektionselement ist bevorzugt als aktiver Freilauf, insbesondere für eine induktive Last, ausgebildet.

Das erste und zweite Transistorelement sind jeweils mit ihrem Emitteranschluss bzw. Sourceanschluss mit dem Detektionselement verbunden und das elektrische Auswertesignal ist ein Auswertestrom, dessen Stromstärke sich zumindest aus einem Teil des Detektionselementstroms ergibt, welcher durch das zweite Transistorelement verstärkt wird. Der Auswertestrom ist dabei der Kollektorstrom bzw. Drainstrom des zweiten Transistorelements.

Es ist bevorzugt, dass der Spannungsabfall an dem Detektionselement an einem Spiegelwiderstand mittels des ersten und zweiten Transistorelements gespiegelt wird, so dass an diesem Spiegelwiderstand im Wesentlichen der gleiche Spannungsbetrag wie an bzw. über dem Detektionselement anliegt.

Das erste und zweite Transistorelement sind vorzugsweise jeweils mittels eines Diodenelements zur Entkopplung mit dem Detektionselement verbunden, wobei diese Diodenelemente insbesondere jeweils in Richtung vom Detektionselement zu dem ersten und zweiten Transistorelement sperrend ausgebildet bzw. angeordnet sind. Diese Diodenelemente sind besonders bevorzugt als Diode oder als Diodenstrecke eines Transistorelements ausgebildet, wobei die Diodenelemente ganz besonders bevorzugt thermisch miteinander gekoppelt sind.

Das Detektionselement ist bevorzugt als Halbleiterschalterelement ausgebildet oder Teil eines Halbleiterschalterelements, welches insbesondere als Treiberelement eines Rezirkulationspfads in einer elektronischen, puls-weiten-modulierten Ventilansteuerungsschaltung ausgebildet ist.

Das Auswertesignal wird vorzugsweise einer Ansteuerungsschaltung zugeführt, welche das Halbleiterschalterelement ansteuert. Die Ansteuerungsschaltung umfasst insbesondere ein FlipFlop, besonders bevorzugt ein RS-FlipFlop.

Es ist bevorzugt, dass das einen Freilaufstrom aktiv führende Halbleiterschalterelement, in Abhängigkeit des Auswertesignals und/oder eines Laststroms durch die induktive Last von der Ansteuerungsschaltung angesteuert wird. Dabei wird das Halbleiterschalterelement insbesondere bei Überschreiten eines definierten Detektionselementstroms und/oder eines definierten Laststroms durch die induktive Last durchgeschaltet.

Die Ansteuerungsschaltung umfasst zweckmäßigerweise eine Halteschaltung und eine Rücksetzschaltung. Dabei legt die Halteschaltung insbesondere zumindest einen Teil des Auswertesignals direkt oder indirekt an einen Steueranschluss bzw. den Basis- oder Gateanschluss des Halbleiterschalterelements und schaltet dieses bei Überschreitung eines definierten Detektionselementstroms durch. Zusätzlich wird dieser durchgeschaltete Zustand nach der Überschreitung des definierten Detektionselementstroms durch einen elektronischen Selbsthaltekreis konserviert. Die Rücksetzschaltung ist besonders bevorzugt so ausgebildet, dass sie diese Zustandskonservierung beenden kann, indem sie ganz besonders bevorzugt zumindest einen Teil des Selbsthaltekreises mit Masse verbindet und/oder ein Massepotential und/oder ein definiertes Potential an den Steueranschluss des Halbleiterschalterelements anlegt, wodurch dieses sperrt.

Die Ansteuerungsschaltung wird zweckmäßigerweise in Abhängigkeit einer PWM-Regelung von einem PWM-Einschaltsignal und/oder einem PWM-Ausschaltsignal bzw. einem PWM-Steuerungssignal angesteuert, wobei insbesondere die Rücksetzschaltung von dem PWM-Einschaltsignal angesteuert wird, wodurch der Haltezustand der Halteschaltung beendet wird, besonders bevorzugt kurz vor dem Beginn einer Einschaltphase bzw. kurz vor dem Ende einer Rezirkulationsphase. Hierdurch wird ein möglicher Kurzschluss durch das Halbleiterschalterelement zu Beginn einer Einschaltphase verhindert, falls ein definierter Detektionselementstrom bzw. Freilaufstrom in der vorigen Rezirkulationsphase überschritten war und deshalb das Halbleiterschalterelement zwecks eines aktiven Freilaufs von der Ansteuerungsschaltung durchgeschaltet ist.

Die induktive Last wird bevorzugt über einen Stromregler angesteuert, wobei der Laststrom mittels eines Tiefsetzstellers auf ein Spannungspotential unterhalb der Versorgungsspannung der Last abgesenkt wird.

Der Tiefsetzsteller umfasst vorzugsweise einen DC/DC-Wandler, welcher mittels einer getakteten Stufe einen Energiespeicher, insbesondere eine Spule oder einen Kondensator, auflädt.

Das erste und zweite Transistorelement sind vorzugsweise thermisch miteinander gekoppelt.

Die elektronische Schaltungseinrichtung ist bevorzugt zumindest teilweise als diskrete Schaltung oder alternativ vorzugsweise zumindest teilweise als integrierte Schaltung ausgebildet.

Die Erfindung bezieht sich außerdem auf die Verwendung der elektronischen Schaltungseinrichtung in Kraftfahrzeugen, insbesondere in einem elektronischen Bremsensteuergerät order einem Fahrwerksteuergerät oder einem Steuergerät für aktive oder passive Sicherheitssysteme oder in einer Kombination dieser Steuergeräte.

Bevorzugte Ausführungsformen ergeben sich aus den Unteransprüchen und den nachfolgenden Beschreibungen von Ausführungsbeispielen an Hand von Figuren.

### Es zeigen in schematischer Darstellung

- Fig. 1: einen getakteten Tiefsetzsteller,
- Fig. 2: einen passiven Freilauf mit einem MOSFET,
- Fig. 3: eine beispielhafte Schaltungseinrichtung zur Erfassung eines Freilaufstroms,
- Fig. 4: ein Ausführungsbeispiel der Schaltungseinrichtung mit einer Ansteuerungsschaltung,
- Fig. 5, 6: zwei beispielhafte Schaltungseinrichtungen mit einer Verpolschutzdiode als Detektionselement, und
- Fig. 7: eine beispielhafte Schaltungseinrichtung zur Strommessung und/oder Überstromerkennung bezüglich eines im Wesentlichen dauerhaft fließenden Detektionselementstroms.

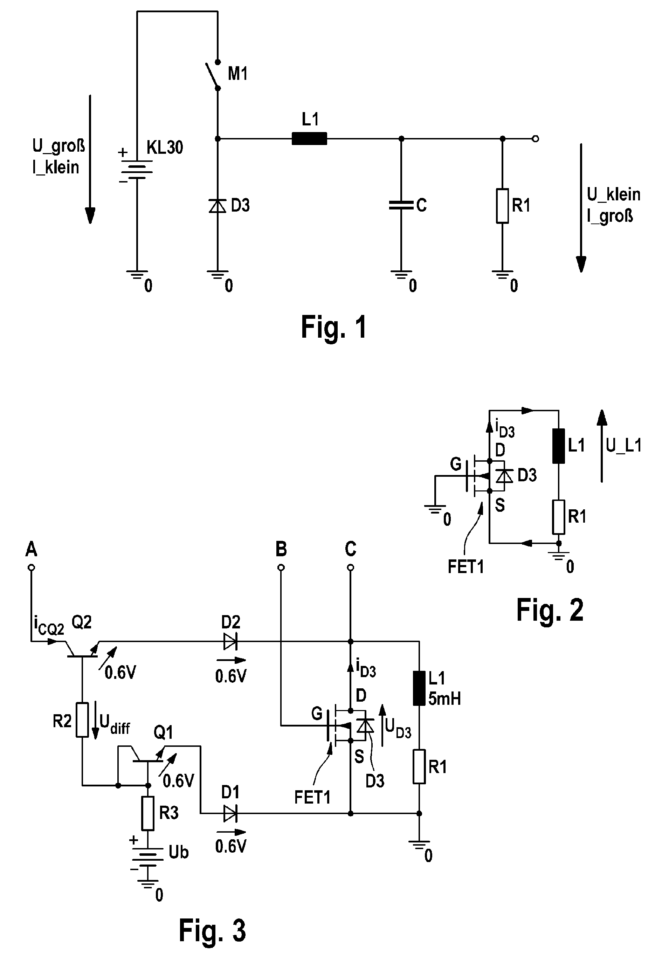

Der beispielhafte Tiefsetzsteller in Fig. 1 umfasst einen getakteten DC/DC-Abwärtswandler mit einer Spule L1 als Energiespeicher bzw. induktive Last. Die Taktung wird mit Halbleiterschalter M1 vorgenommen, welcher abwechselnd geschlossen und geöffnet wird. Durch Öffnen und Schließen des Schalters M1 und geeignete Wahl der Schaltfrequenz wird Spule L1 bis zu einer gewünschten Spannung geladen. Eine Entladung der Spule durch eine angeschlossene Last R1 erfolgt bei geöffnetem Schalter M1 durch eine Entladung von Spule L1, wobei der Strom über Freilaufdiode D3 fließt. Hinter der Spule, parallel zur Last ist ein Kondensator C zur Glättung des periodischen Spulenstroms ähnlich einem Tiefpass 2. Ordnung angeordnet.

Bei der in Fig. 2 dargestellten beispielhaften Schaltungsanordnung fließt ein Freilaufstrom der induktiven Last L1, durch ohmsche Last R1 und durch Halbleiterschalterelement FET1, umfassend Bulkdiode bzw. Freilaufdiode D3, von Anschluss Source S zum Anschluss Drain D. Der Gateanschluss G ist mit einem Bezugspotential (GND, "0") verbunden. Die dargestellte Schaltung arbeitet quasi automatisch, da die Spannung der Last L1, R1 gegenüber dem Bezugspotential hoch genug ist, um Bulkdiode D3 durchzuschalten und so einen Freilauf zu ermöglichen. Die Schaltungsanordnung gemäß Fig. 2 weist jedoch einige Nachteile auf. So ist zum Beispiel der Spannungsabfall über Detektionselement D3 immer noch recht hoch.

In Fig. 3 ist ein Ausführungsbeispiel der elektronischen Schaltungseinrichtung veranschaulicht, welche beispielgemäß zur Erfassung eines Freilaufstroms bzw. Detektionsstroms i_{D3} durch Detektionselement D3 verwendet wird. Detektionselement D3 ist als Bulkdiode bzw. Freilaufdiode des als MOS-FET ausgebildeten Halbleiterschalterelements FET1 ausgebildet. FET1 dient als Leistungstreiber des Rezirkulationspfades einer puls-weiten-modulierten Ventilansteuerungsschaltung, wobei induktive Last L1 und ohmsche Last R1 das elektrische Verhalten des Ventils schematisch abbilden. In einer Einschaltphase der PWM sperrt FET1 und zwischen Klemme C und Masseanschluss "0" liegt eine Versorgungsspannung an, mit welcher das Ventil L1, R1 betrieben wird. In einer Rezirkulationsphase der PWM liegt die Versorgungsspannung nicht an Klemme C an und die in induktiver Last L1 gespeicherte Energie treibt einen Strom durch die Schaltungsmasche L1, R1, FET1, in Durchlassrichtung der Freilaufdiode bzw. des Detektionselements D3. Ein aktiver Freilauf wird beispielgemäß dadurch realisiert, dass der Detektionselementstrom i_{D3} erfasst wird und bei Überschreitung eines definierten Schwellstroms das Halbleiterschalterelement FET1 mittels eines definierten Potentials an Klemme B, welche mit dem Gateanschluss von FET1 verbunden ist, durchgeschaltet wird. Zur Erfassung des Detektionselementstroms i_{D3} weist das Ausführungsbeispiel der Schaltungseinrichtung ein erstes und ein zweites Transistorelement Q1 und Q2 auf, welche jeweils als bipolare Transistoren ausgebildet ist, miteinander thermisch gekoppelt sind und jeweils mit ihrem Emitteranschluss mit dem Detektionselement D3 verbunden sind. Die Steuer- bzw. Basisanschlüsse dieser Transistorelemente Q1 und Q2 sind über Spiegelwiderstand R2 miteinander gekoppelt. Am Basisanschluss von erstem Transistorelement Q1 ist eine Hilfsspannung U_{b} über Widerstandselement R3 angelegt. Basisanschluss und Kollektoranschluss des ersten Transistorelements Q1 sind kurzgeschlossen, so dass lediglich die Basis-Emitter-Diode des ersten Transistorelements Q1 genutzt wird. Bei Vorhandensein eines Detektionsstroms i_{D3} größer 0A bzw. ein durch induktive Last L1 hervorgerufenes negatives Potential am Drainanschluss D gegenüber dem Potential des mit dem Masseanschluss verbundenen Sourceanschlusses S des Halbleiterschalterelements FET1, stellt sich ein im Wesentlichen betraglich gleicher bzw. symmetrischer Spannungsabfall an den Basis-Emitter-Dioden des ersten und zweiten Transistorelements Q1, Q2, von beispielgemäß 0,6V, ein. Erstes und zweites Transistorelement Q1, Q2 spiegeln dabei über Detektionselement D3 abfallende Spannung U_{D3} an Spiegelwiderstand R2, so dass an bzw. über diesem R2 betraglich dieselbe Spannung |U_{diff}| = |U_{D3}| abfällt. Aufgrund dieser Potentialverhältnisse stellt sich ein Auswertestrom i_{CQ2} als elektrisches Auswertesignal am Kollektoranschluss von zweitem Transistorelement Q2 ein. Auswertestrom i_{CQ2} ist dabei ein durch zweites Transistorelement Q2 verstärktes Stromsignal, welches direkt vom Detektionselementstrom i_{D3}, vom Verstärkungsfaktor des zweiten Transistorelements Q2 und im Rezirkulationsfall von der Spannung über Detektionselement D3, D_{D3}, abhängt. Klemme A nimmt den Auswertestrom i_{CQ2} auf, wobei an Klemmen A und B eine nicht dargestellte Ansteuerungsschaltung angeschlossen ist. Diese Ansteuerungsschaltung stellt je nach Stromwert des Auswertestroms i_{CQ2}, beispielgemäß abhängig vom Über- oder Unterschreiten einer definierten Stromschwelle, ein Potential an Klemme B bereit, welches Halbleiterschalterelement bzw. Leistungstreiber FET1 bei Überschreitung durchschaltet und ansonsten gesperrt lässt. Diodenelemente D1 und D2 entkoppeln erstes und zweites Transistorelement Q1, Q2 von Halbleiterschalterelement FET1 in dargestellter Weise. Transistorelemente Q1 und Q2 sind aus Symmetriegründen beispielgemäß gleichartig ausgebildet.

Der Stromschwellenwert, den Auswertestrom i_{CQ2} über- oder unterschreiten muss, damit Halbleiterschalterelement FET1 von der Ansteuerungsschaltung durchgeschaltet wird, hängt maßgeblich vom Widerstandswert des Spiegelwiderstands R2 ab. Zur Ermittlung bzw. Messung des Detektionselementstrom wird beispielhaft der Wert des Auswertestroms i_{CQ2}, wenigstens eine Information über die Strom-Spannungs-Kennlinie bzw. der Verstärkungsfaktor des zweiten Transistorelements Q2 sowie zumindest eine Information über die Strom-Spannungs-Kennlinie des Detektionselements berücksichtigt.

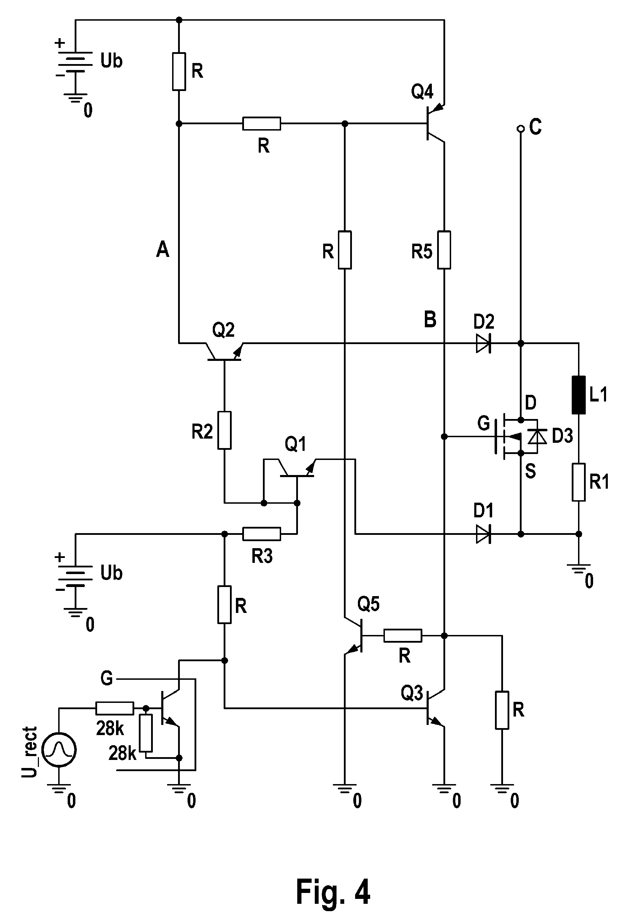

Fig. 4 zeigt eine beispielhafte elektronische Schaltungseinrichtung, welche aufbauend auf der in Fig. 3 veranschaulichten Schaltungseinrichtung Ansteuerungsschaltung 1 umfasst. Ansteuerungsschaltung 1 umfasst dabei eine Halteschaltung 2 sowie eine Rücksetzschaltung 3. Zweites Transistorelement Q2 treibt Auswertestrom i_{CQ2}, welcher abhängig ist vom Detektionselementstrom i_{D3}, vom Verstärkungsfaktor von Q2 und ebenso von dem Spannungsabfall U_{diff} über Spiegelwiderstand R2. Überschreitet Auswertestrom i_{CQ2} bzw. Detektionselementstrom i_{D3} einen definierten Wert, veranlasst Ansteuerungsschaltung 1 einen aktiven Freilauf durch Halbleiterschalterelement FET1, indem Auswertestrom i_{CQ2} bzw. das durch diesen am Steueranschluss des Transistorelements Q4 eingestellte Potential ein Durchschalten von Transistorelement Q4 bewirkt und damit Hilfsspannung Ub bzw. Ub in Abhängigkeit von R5, am Gateanschluss des Halbleiterschalterelements FET1 anliegt und diesen durchschaltet. Dieses Potential schaltet außerdem Transistorelement Q5 durch, welches wiederum für ein definiertes Mindestpotential am Steueranschluss bzw. Basisanschluss von Q4 sorgt, wodurch das Durchschalten von FET1 gehalten wird, unabhängig von Auswertestrom i_{CQ2}. Diese Halteschaltung 2 mit Transistorelementen Q4 und Q5 kann durch Rücksetzschaltung 3 zurückgesetzt bzw. "gelöst" bzw. "gelöscht" werden. Dies geschieht zumindest am Ende der Rezirkulationsphase bzw. am Anfang der Einschaltphase der PWM, indem Transistorelement Q3 der Rücksetzschaltung 3 vom einen PWM-Einschaltsignal U_rect angesteuert wird, wobei dieses Signal U_rect beispielgemäß ein Rechtecksignal der PWM-Regelung ist, und dabei kurz vor bzw. direkt zu Beginn der Einschaltphase Halbleiterschalterelement FET1 in den sperrenden Zustand versetzt, indem es ein Massepotential an dessen Gateanschluss anlegt.

Auswertestrom i_{CQ2} kann alternativ beispielhaft zur analogen Stromschätzung bzw. Strommessung oder auch als rein digitale Stromdetektion ausgewertet werden. Die in Fig. 4 dargestellte Schaltungseinrichtung zeigt eine Ansteuerungsschaltung 1, welche beispielgemäß als eine digitale Stromauswertung mit Hilfe eines bevorzugt diskret aufgebauten RS-FlipFlops mit Transistorelementen Q3, Q4 und Q5 ausgebildet ist.

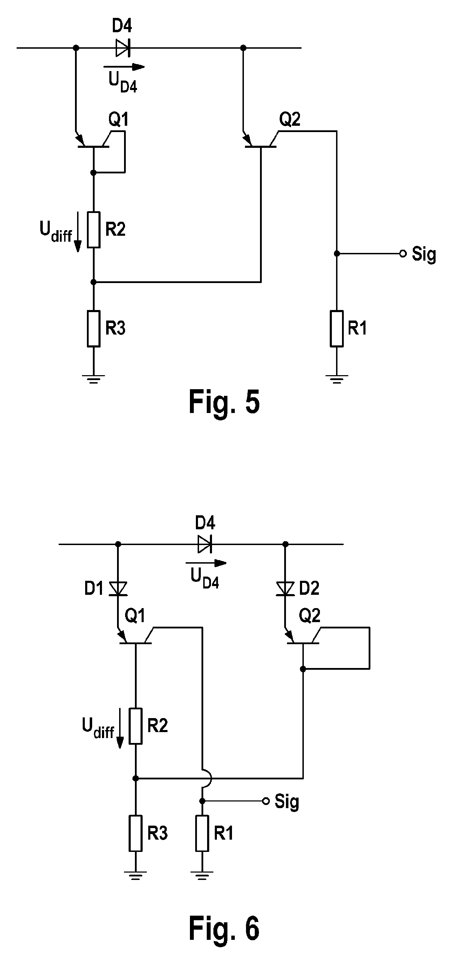

Fig. 5 und 6 zeigen zwei Ausführungsbeispiele von Schaltungseinrichtungen, bei denen Detektionselement D4 jeweils als Verpolschutzdiode ausgebildet ist. Die Eingänge dieser Verpolschutzdiode D4 sind mit dem Emitteranschluss des ersten Transistorelements Q1 und mit dem Emitteranschluss des zweiten Transistorelements Q2 verbunden, deren Basisanschlüsse über Spiegelwiderstand R2 miteinander verbunden sind, über welchem bei Vorliegen einer Spannung U_{D4} über Verpolschutzdiode D4 in deren Durchlassrichtung, eine Spannung U_{diff} mit gleichem Betrag abfällt. In Fig. 5 treibt zweites Transistorelement Q2 einen Kollektorstrom als Auswertestrom, welcher an Klemme Sig bereitgestellt wird. In Fig. 6 treibt erstes Transistorelement Q1 kollektorseitig diesen Auswertestrom. Der von Klemme Sig aufgenommene Auswertestrom wird beispielgemäß in einer nicht dargestellten Auswerteschaltung zur Ermittlung des durch Detektionselement fließenden Detektionselementstrom bzw. zur Ermittlung der Temperatur im Detektionselement berücksichtigt. Dabei werden außerdem die Bauteileigenschaften der Verpolschutzdiode D4 sowie des Transistorelement Q1 bzw. Q2, welches den Auswertestrom treibt, berücksichtigt. Zur Ermittlung der Temperatur sollte beispielhaft wenigstens eine Information über den Strom vorliegen und andersherum.

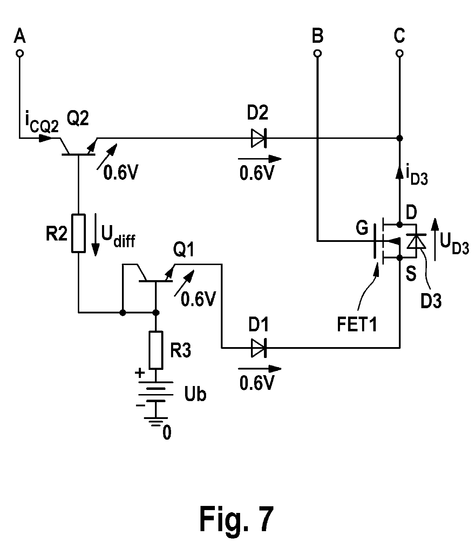

In Fig. 7 ist eine beispielhafte Schaltungseinrichtung dargestellt, bei welcher Halbleiterschalterelement FET1 mit Detektionselement D3 einen Verpolschutz bilden und Detektionselementstrom i_{D3} bzw. der Strom durch FET 1 als ein im Wesentlichen dauerhafter Ausgleichsstrom ausgeprägt ist. Mittels der beispielgemäßen Schaltungsanordnung, die im Übrigen entsprechend der in Fig. 3 gezeigten Schaltungseinrichtung aufgebaut ist, wird der Strom durch Detektionselement D3 gemessen und/oder eine Überstromerkennung bzw. eine Kurzschlussstromerkennung durchgeführt.

## Patentansprüche

1. Elektronische Schaltungseinrichtung zur Erfassung eines Detektionselementstroms (i_{D3}) durch ein Detektionselement (D3, D4), und/oder einer Temperatur in diesem Detektionselement (D3, D4), mit einem ersten und einem zweiten Transistorelement und mit dem als Freilaufdiode oder als Verpolschutzdiode ausgebildeten und mit einer induktiven Last in Verbindung stehenden Detektionselement,
wobei ein erster Anschluss des Detektionselements (D3, D4) mit einem Emitteranschluss bzw. Sourceanschluss des ersten Transistorelements (Q1) verbunden ist und ein zweiter Anschluss des Detektionselements (D3, D4) mit einem Emitteranschluss bzw. Sourceanschluss des zweiten Transistorelements (Q2) verbunden ist, **dadurch gekennzeichnet, dass** die Basisanschlüsse des ersten und zweiten Transistorelements (Q1, Q2) direkt oder indirekt miteinander verbunden sind und das zweite Transistorelement (Q2) ein elektrisches Auswertesignal (i_{CQ2}) bereitstellt und/oder moduliert, wobei das elektrische Auswertesignal der Kollektorstrom bzw. Drainstrom des zweiten Transistorelements ist, dessen Signalwert wenigstens von dem Detektionselementstrom (i_{D3}) und/oder der Temperatur in dem Detektionselement (D3, D4) direkt oder indirekt abhängt.

2. Schaltungseinrichtung nach Anspruch 1, **dadurch gekennzeichnet, dass** das Detektionselement (D3) als Freilaufdiode ausgebildet ist, welche in einer gemeinsamen Schaltungsmasche mit einer induktiven Last (L1) angeordnet ist und diese induktive Last (L1) insbesondere als Ventilspule und/oder als Motor ausgebildet ist.

3. Schaltungseinrichtung nach mindestens einem der Ansprüche 1 und 2, **dadurch gekennzeichnet, dass** das erste und das zweite Transistorelement (Q1, Q2) jeweils mit ihrem Emitteranschluss mit dem Detektionselement (D3, D4) verbunden sind und das elektrische Auswertesignal (i_{CQ2}) insbesondere ein Auswertestrom ist, dessen Stromstärke sich zumindest aus einem Teil des Detektionselementstroms (i_{D3}) ergibt, welcher durch das zweite Transistorelement (Q2) verstärkt wird.

4. Schaltungseinrichtung nach mindestens einem der Ansprüche 1 bis 3, **dadurch gekennzeichnet, dass** der Spannungsabfall (U_{D3}, U_{D4}) an dem Detektionselement (D3, D4) an einem Spiegelwiderstand (R2) mittels des ersten und zweiten Transistorelements (Q1, Q2) gespiegelt wird, so dass an diesem Spiegelwiderstand (R2) im Wesentlichen der gleiche Spannungsbetrag (U_{diff}) wie an dem Detektionselement (D3, D4) anliegt.

5. Schaltungseinrichtung nach mindestens einem der Ansprüche 1 bis 4, **dadurch gekennzeichnet, dass** das erste und zweite Transistorelement (Q1, Q2) jeweils mittels eines Diodenelements (D1, D2) zur Entkopplung mit dem Detektionselement (D3, D4) verbunden sind, wobei diese Diodenelemente (D1, D2) insbesondere jeweils in Richtung vom Detektionselement (D3, D4) zu dem ersten und zweiten Transistorelement (Q1, Q2) sperrend ausgebildet sind.

6. Schaltungseinrichtung nach Anspruch 5, **dadurch gekennzeichnet, dass** die Diodenelemente (D1, D2) jeweils als Diode oder als Diodenstrecke eines Transistorelements ausgebildet sind, wobei die Diodenelemente (D1, D2) insbesondere thermisch miteinander gekoppelt sind.

7. Schaltungseinrichtung nach mindestens einem der Ansprüche 1 bis 6, **dadurch gekennzeichnet, dass** das Detektionselement (D3) als Halbleiterschalterelement ausgebildet ist oder Teil eines Halbleiterschalterelements (FET1) ist, welches insbesondere als Treiberelement eines Rezirkulationspfads in einer elektronischen, puls-weiten-modulierten Ventilansteuerungsschaltung ausgebildet ist.

8. Schaltungseinrichtung nach Anspruch 7, **dadurch gekennzeichnet, dass** das Auswertesignal (i_{CQ2}) einer Ansteuerungsschaltung (1) zugeführt wird, welche das Halbleiterschalterelement (FET1) ansteuert.

9. Schaltungseinrichtung nach Anspruch 8, **dadurch gekennzeichnet, dass** die Ansteuerungsschaltung (1) ein FlipFlop, insbesondere ein RS-FlipFlop, umfasst.

10. Schaltungseinrichtung nach Anspruch 8 oder 9, **dadurch gekennzeichnet, dass** die Ansteuerungsschaltung (1) eine Halteschaltung (2) und eine Rücksetzschaltung (3) umfasst.

11. Schaltungseinrichtung nach mindestens einem der Ansprüche 8 bis 10, **dadurch gekennzeichnet, dass** die Ansteuerungsschaltung (1) in Abhängigkeit einer PWM-Regelung von einem PWM-Einschaltsignal (U_rect) und/oder einem PWM-Ausschaltsignal angesteuert wird, wobei insbesondere die Rücksetzschaltung (3) von dem PWM-Einschaltsignal (U_rect) angesteuert wird, wodurch ein Haltezustand der Halteschaltung beendet wird.

12. Schaltungseinrichtung nach mindestens einem der Ansprüche 2 bis 11, **dadurch gekennzeichnet, dass** die induktive Last (L1) über einen Stromregler angesteuert wird, wobei der Laststrom mittels eines Tiefsetzstellers auf ein Spannungspotential unterhalb der Versorgungsspannung abgesenkt wird.

13. Schaltungseinrichtung nach mindestens einem der Ansprüche 1 bis 12, **dadurch gekennzeichnet, dass** das erste und zweite Transistorelement(Q1, Q2) thermisch miteinander gekoppelt sind.

14. Verfahren zur Stromerfassung in einer elektronischen Schaltungseinrichtung nach mindestens einem der Ansprüche 1 bis 13, **dadurch gekennzeichnet, dass** eine erste Information über die Temperatur und/oder den Detektionselementstrom (i_{D3}) im und/oder durch das Detektionselement (D3, D4) sowie wenigstens eine zweite Information über die Strom-Spannungs-Kennlinie des Detektionselements in einer elektronischen Kontrolleinheit und/oder in der Schaltungseinrichtung verfügbar sind und dass aus dem Signalwert des Auswertesignals (i_{CQ2}) und zumindest der ersten und zweiten Information direkt oder indirekt der Detektionselementstrom (i_{D3}) und/oder die Temperatur im Detektionselement (D3, D4) ermittelt wird.

15. Verwendung der elektronischen Schaltungseinrichtung nach mindestens einem der Ansprüche 1 bis 13 in Kraftfahrzeugen, insbesondere in einem elektronischen Bremsensteuergerät oder einem Fahrwerksteuergerät oder einem Steuergerät für aktive oder passive Sicherheitssysteme oder in einer Kombination dieser Steuergeräte.

## Claims

1. Electronic circuit device for sensing a detection element current (i_{D3}) through a detection element (D3, D4),
and/or a temperature in said detection element (D3, D4), with a first and a second transistor element and with the detection element which is in the form of a freewheeling diode or in the form of a polarity reversal protection diode and connected to an inductive load,
wherein a first connection of the detection element (D3, D4) is connected to an emitter connection or source connection of the first transistor element (Q1) and a second connection of the detection element (D3, D4) is connected to an emitter connection or source connection of the second transistor element (Q2), **characterized in that**
the base connections of the first and second transistor elements (Q1, Q2) are connected to one another directly or indirectly and the second transistor element (Q2) provides and/or modulates an electrical evaluation signal (i_{CQ2}), wherein the electrical evaluation signal is the collector current or drain current of the second transistor element, the signal value of which electrical evaluation signal is directly or indirectly dependent at least on the detection element current (i_{D3}) and/or the temperature in the detection element (D3, D4).

2. Circuit device according to Claim 1, **characterized in that** the detection element (D3) is in the form of a freewheeling diode which is arranged in a common circuit mesh with an inductive load (L1), and said inductive load (L1) is particularly in the form of a valve coil and/or in the form of a motor.

3. Circuit device according to at least one of Claims 1 and 2, **characterized in that** the first and second transistor elements (Q1, Q2) each have their emitter connection connected to the detection element (D3, D4), and the electrical evaluation signal (i_{CQ2}) is particularly an evaluation current, the amperage of which is obtained at least from a portion of the detection element current (i_{D3}) which is amplified by the second transistor element (Q2).

4. Circuit device according to at least one of Claims 1 to 3, **characterized in that** the voltage drop (U_{D3}, U_{D4}) across the detection element (D3, D4) is mirrored on a mirror resistor (R2) by means of the first and second transistor elements (Q1, Q2), so that said mirror resistor (R2) has essentially the same voltage magnitude (U_{diff}) across it as the detection element (D3, D4) .

5. Circuit device according to at least one of Claims 1 to 4, **characterized in that** the first and second transistor elements (Q1, Q2) are each connected to the detection element (D3, D4) by means of a diode element (D1, D2) for decoupling, wherein said diode elements (D1, D2) are in blocking form particularly in each case in the direction from the detection element (D3, D4) to the first and second transistor elements (Q1, Q2).

6. Circuit device according to Claim 5, **characterized in that** the diode elements (D1, D2) are each in the form of a diode or in the form of a diode path of a transistor element, wherein the diode elements (D1, D2) are coupled to one another, in particular thermally.

7. Circuit device according to at least one of Claims 1 to 6, **characterized in that** the detection element (D3) is in the form of a semiconductor switch element or is part of a semiconductor switch element (FET1) which is particularly in the form of a driver element of a recirculation path in an electronic, pulse-width-modulated valve actuation circuit.

8. Circuit device according to Claim 7, **characterized in that** the evaluation signal (i_{CQ2}) is supplied to an actuation circuit (1) which actuates the semiconductor switch element (FET1).

9. Circuit device according to Claim 8, **characterized in that** the actuation circuit (1) comprises a flipflop, particularly an RS-type flipflop.

10. Circuit device according to Claim 8 or 9, **characterized in that** the actuation circuit (1) comprises a hold circuit (2) and a reset circuit (3).

11. Circuit device according to at least one of Claims 8 to 10, **characterized in that** the actuation circuit (1) is actuated on the basis of PWM regulation of a PWM switch-on signal (U_rect) and/or a PWM switch-off signal, wherein particularly the reset circuit (3) is actuated by the PWM switch-on signal (U rect), which terminates a hold state of the hold circuit.

12. Circuit device according to at least one of Claims 2 to 11, **characterized in that** the inductive load (L1) is actuated via a current regulator, wherein the load current is lowered to a voltage potential below the supply voltage by means of a step-down controller.

13. Circuit device according to at least one of Claims 1 to 12, **characterized in that** the first and second transistor elements (Q1, Q2) are coupled to one another thermally.

14. Method for current sensing in an electronic circuit device according to at least one of Claims 1 to 13, **characterized in that**
a first piece of information about the temperature and/or the detection element current (i_{D3}) in and/or through the detection element (D3, D4) and at least one second piece of information about the current/voltage characteristic of the detection element are available in an electronic control unit and/or in the circuit device and **in that** the signal value of the evaluation signal (i_{CQ2}) and at least the first and second pieces of information are used to ascertain the detection element current (i_{D3}) and/or the temperature in the detection element (D3, D4) directly or indirectly.

15. Use of the electronic circuit device according to at least one of Claims 1 to 13 in motor vehicles, particularly in an electronic brake controller or a chassis controller or a controller for active or passive safety systems or in a combination of these controllers.

## Revendications

1. Dispositif de circuit électronique destiné à détecter un courant (i_{D3}) d'un élément de détection, à travers un élément de détection (D3, D4),
et/ou une température dans ledit élément de détection (D3, D4), avec un premier et un deuxième élément transistor et avec un élément de détection conçu en tant que diode de roue libre ou en tant que diode de protection contre l'inversion de polarité et qui est en liaison avec une charge inductive,
une première borne de l'élément de détection (D3, D4) étant reliée avec une borne émettrice ou borne source du premier élément transistor (Q1) et une deuxième borne de l'élément de détection (D3, D4) étant reliée avec une borne émettrice ou borne source du deuxième élément transistor (Q2), **caractérisé en ce que**
les bornes de base du premier et du deuxième élément transistor (Q1, Q2) sont directement ou indirectement connectées l'une à l'autre et le deuxième élément transistor (Q2) met à disposition et/ou module un signal d'évaluation (i_{CQ2}) électrique, le signal d'évaluation électrique étant le courant collecteur ou courant de drain du deuxième élément transistor dont la valeur de signal dépend directement ou indirectement au moins du courant (i_{D3}) de l'élément de détection et/ou de la température dans l'élément de détection (D3, D4).

2. Dispositif de circuit selon la revendication 1, **caractérisé en ce que** l'élément de détection (D3) est conçu en tant que diode de roue libre, laquelle est placée dans une maille de circuit commune avec une charge inductive (L1) et cette charge inductive (L1) est conçue notamment en tant que bobine de soupape et/ou en tant que moteur.

3. Dispositif de circuit selon au moins l'une quelconque des revendications 1 et 2, **caractérisé en ce que** le premier et le deuxième élément transistor (Q1, Q2) sont connectés chacun par sa borne émettrice avec l'élément de détection (D3, D4) et le signal d'évaluation électrique (i_{CQ2}) est notamment un courant d'évaluation dont l'intensité de courant résulte au moins d'une partie du courant (i_{D3}) de l'élément de détection, lequel est amplifié par le deuxième élément transistor (Q2).

4. Dispositif de circuit selon au moins l'une quelconque des revendications 1 à 3, **caractérisé en ce que** la chute de tension (U_{D3}, U_{D4}) sur l'élément de détection (D3, D4) est reflétée sur une résistance miroir (R2) au moyen du premier et du deuxième élément transistor (Q1, Q2), de sorte que sur ladite résistance miroir (R2) soit appliquée sensiblement la même valeur de tension (U_{diff}) que sur l'élément de détection (D3, D4).

5. Dispositif de circuit selon au moins l'une quelconque des revendications 1 à 4, **caractérisé en ce que** le premier et le deuxième élément transistor (Q1, Q2) sont connectés chaque fois au moyen d'un élément à diodes (D1, D2) pour le découplage avec l'élément de détection (D3, D4), lesdits éléments à diodes (D1, D2) étant conçus chacun pour former blocage vers le premier et le deuxième élément transistor (Q1, Q2), notamment en direction de l'élément de détection (D3, D4).

6. Dispositif de circuit selon la revendication 5, **caractérisé en ce que** les éléments à diodes (D1, D2) sont conçus chaque fois en tant que diode ou en tant que trajet de diodes d'un élément transistor, les éléments à diodes (D1, D2) étant couplés les uns aux autres, notamment thermiquement.

7. Dispositif de circuit selon au moins l'une quelconque des revendications 1 à 6, **caractérisé en ce que** l'élément de détection (D3) est conçu en tant qu'élément commutateur à semi-conducteur ou est une partie d'un élément commutateur à semi-conducteur (FET1), lequel est conçu notamment en tant qu'élément excitateur d'un trajet de recirculation dans un circuit électronique d'amorçage de soupape à modulation d'impulsions en largeur.

8. Dispositif de circuit selon la revendication 7, **caractérisé en ce que** le signal d'évaluation (i_{CQ2}) est amené vers un circuit d'amorçage (1), lequel amorce l'élément commutateur à semi-conducteur (FET1).

9. Dispositif de circuit selon la revendication 8, **caractérisé en ce que** le circuit d'amorçage (1) comprend une bascule, notamment une bascule RS.

10. Dispositif de circuit selon la revendication 8 ou la revendication 9, **caractérisé en ce que** le circuit d'amorçage (1) comprend un circuit de retenue (2) et un circuit de réinitialisation (3).

11. Dispositif de circuit selon au moins l'une quelconque des revendications 8 à 10, **caractérisé en ce que** le circuit d'amorçage (1) est amorcé en fonction d'une régulation PWM d'un signal d'activation PWM (U_rect) et/ou d'un signal de désactivation PWM, notamment le circuit de réinitialisation (3) étant amorcé par le signal d'activation PWM (U_rect), suite à quoi un état de retenue du circuit de retenue prend fin.

12. Dispositif de circuit selon au moins l'une quelconque des revendications 2 à 11, **caractérisé en ce que** la charge inductive (L1) est amorcée par l'intermédiaire d'un régulateur de courant, le courant de charge étant abaissé au moyen d'un convertisseur-abaisseur à un potentiel de tension inférieur à la tension d'alimentation.

13. Dispositif de circuit selon au moins l'une quelconque des revendications 1 à 12, **caractérisé en ce que** le premier et le deuxième élément transistor (Q1, Q2) sont thermiquement couplés l'un à l'autre.

14. Procédé destiné à détecter le courant dans un dispositif de circuit électronique selon au moins l'une quelconque des revendications 1 à 13, **caractérisé en ce qu'**une première information est disponible par l'intermédiaire de la température et/ou du courant (i_{D3}) de l'élément de détection dans et/ou à travers l'élément de détection (D3, D4), ainsi qu'au moins une deuxième information est disponible par l'intermédiaire de la courbe caractéristique courant-tension de l'élément de détection dans une unité de contrôle électronique et/ou dans le dispositif de circuit et **en ce qu'**à partir de la valeur de signal du signal d'évaluation (i_{CQ2}) et au moins de la première et de la deuxième information, le courant (i_{D3}) de l'élément de détection et/ou la température dans l'élément de détection (D3, D4) est/sont directement ou indirectement déterminé(s).

15. Utilisation du dispositif de circuit électronique selon au moins l'une quelconque des revendications 1 à 13 dans des véhicules automobiles, notamment dans un instrument électronique de contrôle de freinage ou dans un instrument de contrôle du châssis ou dans un instrument de contrôle pour des systèmes de sécurité actifs ou passifs ou dans une association desdits instruments de contrôle.
